# EUROPÄISCHE PATENTANMELDUNG

(11) **EP 1 931 188 A1**
(43) Veröffentlichungstag der Anmeldung: **11.06.2008**
(21) Anmeldenummer: 06025241.8
(22) Anmeldetag: 06.12.2006
(51) Int. Cl.: H05K 5/02

(54) **Leittechnikschrank für eine Industrieanlage**

(71) Anmelder: SIEMENS AKTIENGESELLSCHAFT, 80333 München (DE)
(72) Erfinder: Ebner, Günther, 91466 Gerhardshofen (DE)

(57) **Zusammenfassung**

Die Erfindung betrifft einen Leittechnikschrank (10) für eine Industrieanlage, mit wenigstens einer innerhalb des Leittechnikschranks (10) angeordneten Anschlussklemme (16), die wenigstens eine Klemmvorrichtung (18) zum Anschluss wenigstens einer Ader (26) eines von außerhalb des Leittechnikschranks (10) zugeführten Kabels aufweist, und ferner wenigstens eine weitere Klemmvorrichtung (18) zum Anschluss wenigstens einer Ader (28) eines Kabels einer internen Verdrahtung des Leittechnikschranks (10) aufweist, wobei jede Klemmvorrichtung (18) eine Einführ-Richtung aufweist, in welcher die Ader (26, 28) zum Anschluss an die Anschlussklemme (16) in die Klemmvorrichtung (18) eingeführt wird, und wobei die Einführ-Richtung der Klemmvorrichtung (18), die zum Anschluss der Ader (26) des von außerhalb des Leittechnikschranks (10) zugeführten Kabels vorgesehen ist, gegenüber der Einführ-Richtung der Klemmvorrichtung (18), die zum Anschluss der Ader (28) des Kabels der internen Verdrahtung des Leittechnikschranks (10) vorgesehen ist, um einen vorgegebenen Winkel geneigt ist.

## Beschreibung

Die Erfindung betrifft einen Leittechnikschrank für eine Industrieanlage, mit wenigstens einer innerhalb des Leittechnikschranks angeordneten Anschlussklemme, die wenigstens eine Klemmvorrichtung zum Anschluss wenigstens einer Ader eines von außerhalb des Leittechnikschranks zugeführten Kabels aufweist, und ferner wenigstens eine weitere Klemmvorrichtung zum Anschluss wenigstens einer Ader eines Kabels einer internen Verdrahtung des Leittechnikschranks aufweist, wobei jede Klemmvorrichtung eine Einführ-Richtung aufweist, in welcher die Ader zum Anschluss an die Anschlussklemme in die Klemmvorrichtung eingeführt wird.

In einem Leittechnikschrank einer Industrieanlage sind in der Regel viele elektrische Komponenten miteinander zu verdrahten. Dies hat zur Folge, dass der in einem Leittechnikschrank vorhandene Platz optimal ausgenutzt werden muss. Ein großer Anteil des in einem Leittechnikschrank vorhandenen Raums ist hierbei für die Verdrahtung vorgesehen.

Feldkabel bzw. von außerhalb des Schranks zugeführte Kabel werden in der Regel von der Seite in den Schrank geführt und an Anschlussklemmen angeschlossen, die an der Schrankrückwand angebracht sind. Dadurch, dass die Kabel von der Seite in den Schrank geführt werden, muss für das Heranführen und Anklemmen des abgesetzten Feldkabels (also der Adern und damit der isolierten Leiter des Feldkabels) an die Anschlussklemmen ausreichend Platz zur Verfügung gestellt werden. Dies ist insbesondere darauf zurückzuführen, dass die Klemmvorrichtungen einer Anschlussklemme, die zum Anschluss eines Feldkabels vorgesehen sind, den Klemmvorrichtungen der Anschlussklemme gegenüberliegen, die zum Anschluss eines Kabels der internen Verdrahtung des Leittechnikschranks vorgesehen sind. Diese bekannte Anordnung der Klemmvorrichtungen einer Anschlussklemme hat zur Folge, dass die Adern des Feldkabels zum Anschluss an die Anschlussklemme umgebogen bzw. abgewinkelt werden müssen. Hierbei ist streng darauf zu achten, dass die Adern nicht zu eng umgebogen werden, da durch die so vorgenommene Kaltverformung die Ader bzw. der Aderdraht brechen kann. Für die notwendige Abwinkelung bzw. Umbiegung muss innerhalb des Leittechnikschranks ein hinreichend hoher Platz reserviert werden, der sich insgesamt nachteilig auf das gesamte Aufnahmevermögen eines Leittechnikschranks auswirkt. Oftmals sind die Platzverhältnisse in einem Leittechnikschrank jedoch derart eng bemessen, dass ein Anklemmen nur schwer möglich ist.

### Zugrundeliegende Aufgabe

Der Erfindung liegt die Aufgabe zugrunde, einen Leittechnikschrank anzugeben, mit dem der für die Verkabelung bereitzustellende Platzbedarf gegenüber bekannten Lösungen deutlich verringert werden kann.

### Erfindungsgemäße Lösung

Diese Aufgabe ist erfindungsgemäß mit dem eingangs genannten Leittechnikschrank gelöst, bei dem die Einführ-Richtung der Klemmvorrichtung, die zum Anschluss der Ader des von außerhalb des Leittechnikschranks zugeführten Kabels vorgesehen ist, gegenüber der Einführ-Richtung der Klemmvorrichtung, die zum Anschluss der Ader des Kabels der internen Verdrahtung des Leittechnikschranks vorgesehen ist, um einen vorgegebenen Winkel geneigt ist.

Mittels dieser erfindungsgemäß vorgenommenen Ausbildung der Anschlussklemmen kann durch geeignete Wahl des vorgegebenen Neigungswinkels der Einführ-Richtungen das Maß um den die Adern des von außerhalb zugeführten Kabels umgebogen bzw. abgewinkelt werden müssen, deutlich reduziert werden. Der im Leittechnikschrank für die Verkabelung bereitzustellende Platz kann so deutlich reduziert werden, wobei der freiwerdende zusätzliche Platz im Leittechnikschrank beispielsweise die Installation weiterer elektrischer Komponenten ermöglicht. Schließlich ist mit dem erfindungsgemäßen Leittechnikschrank ein zeitsparendes, deutlich leichteres und damit bequemeres Anschließen der Feldkabel möglich.

### Vorteilhafte Weiterbildungen der Erfindung

Bei einer vorteilhaften Weiterbildung ist der vorgegebene Winkel, um den die Einführ-Richtungen zueinander geneigt sind ein rechter Winkel. So kann erfindungsgemäß ein Anklemmen von um 90 Grad versetzt herangeführten Kabeln ohne Umbiegung der Kabeladern ermöglicht werden. Dies hat den Vorteil, dass bei einem sonst üblichen Aufbau des Leittechnikschranks Kabel, die von der Seite in den Leittechnikschrank eingeführt werden, an die Anschlussklemme angeschlossen werden können, und zwar ohne eine Umbiegung der Adern des Kabels vornehmen zu müssen. So kann auf einfache und platzsparende Weise eine leitende Verbindung zu einem entsprechenden Kabel der internen Verdrahtung des Leittechnikschranks vorgenommen werden. Vorzugsweise handelt es bei der Anschlussklemme um eine, vorzugsweise um 90 Grad, abgewinkelte Anschlussklemme.

Bei einer weiteren praktischen Weiterbildung ist die Anschlussklemme an einer Schrankwand, vorzugsweise einer Rückwand des Leittechnikschranks angeordnet.

Bei einer vorteilhaften Weiterbildung ist die Anschlussklemme bzw. sind die Anschlussklemmen auf einer Montageplatte angebracht. Die Montageplatte kann in beliebigen Leittechnikschränken eingesetzt werden, und zwar ohne sog. "Fliegende Klemmleisten" auf der jeweiligen Industrieanlage in die Schrankseitenwände zu montieren. Auf diese Weise wird erfindungsgemäß auch die Schrankfertigung vereinfacht.

Bei einer weiteren praktischen Weiterbildung weist der Leittechnikschrank eine Seitenwand auf, in der eine Öffnung zur Durchführung des von außerhalb des Leittechnikschranks zugeführten Kabels, beispielsweise in Form eines Feldkabels, ausgebildet ist.

### Kurzbeschreibung der Zeichnungen

Nachfolgend werden Ausführungsbeispiele eines erfindungsgemäßen Leittechnikschranks anhand der beigefügten Zeichnungen näher erläutert. Es zeigen:
- FIG 1: eine schematische Schnittansicht eines Ausschnitts eines erfindungsgemäßen Leittechnikschranks in Draufsicht, und
- FIG 2: in Draufsicht links schematisch einen Ausschnitt eines erfindungsgemäßen Leittechnikschranks und rechts einen Ausschnitt eines Leittechnikschranks gemäß des Stands der Technik

### Detaillierte Beschreibung der Ausführungsbeispiele

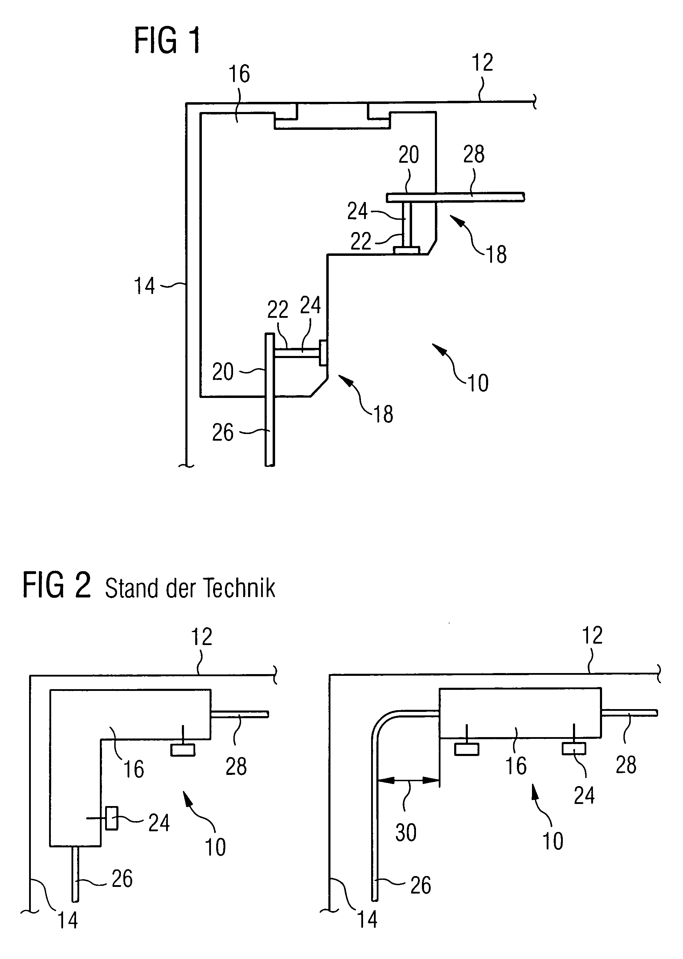

FIG 1 zeigt eine Schnittansicht eines Ausschnitts eines erfindungsgemäßen Leittechnikschranks 10 in Draufsicht.

Der Leittechnikschrank 10 weist eine Schrankrückwand 12 und eine Seitenwand 14 auf. An der Schrankrückwand 12 ist eine erfindungsgemäße Anschlussklemme 16 angebracht, die vorliegend in Form einer um 90 Grad abgewinkelten Anschlussklemme 16 ausgebildet ist. Die Anschlussklemme 16 weist zwei Klemmvorrichtungen 18 auf, umfassend jeweils eine in der Anschlussklemme 16 ausgebildete zylindrische Öffnung 20 zur Aufnahme einer Ader eines Kabels, eine sich von außerhalb der Anschlussklemme 16 quer zur Längsrichtung der zylindrischen Öffnung 20 in die zylindrische Öffnung 20 erstreckende Gewindebohrung 22, und eine Klemmschraube 24, die zum Einklemmen einer in der Öffnung 20 aufgenommenen Ader in die Gewindebohrung 22 eingeschraubt wird.

Längs der Seitenwand 14 erstreckt sich die Ader 26 eines Feldkabels (in der FIG 1 ist nur die Ader 26 des Feldkabels dargestellt), welches sich von außerhalb des Leittechnikschranks 10 in diesen erstreckt. Zum Anschluss des Feldkabels an die Anschlussklemme 16 wurde die Ader 26 (nach Abisolierung ) in die zylindrische Öffnung 20 eingeführt und anschließend durch Eindrehen der Klemmschraube 24 an der Anschlussklemme 16 festgeklemmt. Erfindungsgemäß ist hierfür kein Umbiegen bzw. Abwinkeln der Ader 26 notwendig, wie es aus dem Stand der Technik bekannt ist.

In der zweiten Klemmvorrichtung 18 ist die Ader 28 eines Kabels einer schrankinternen Verdrahtung festgeklemmt, so dass über die Anschlussklemme 16 eine leitende Verbindung zwischen dem Feldkabel, das beispielsweise ein Signalübertragungskabel für eine außerhalb des Leittechnikschranks 10 angeordnete Sensorik ist, und dem Kabel der schrankinternen Verdrahtung realisiert wird.

Zur Verdeutlichung der erfindungsgemäßen Vorteile gegenüber dem Stand der Technik zeigt FIG 2 in Draufsicht links schematisch einen Ausschnitt eines erfindungsgemäßen Leittechnikschranks 10 und rechts einen Ausschnitts eines Leittechnikschranks 10 gemäß des Stands der Technik.

Dem rechten Ausschnitt in FIG 2 ist zu entnehmen, dass (abgesehen von der Orientierung) bei gleicher Einführ-Richtung für die Ader 26 des Feldkabels und die Ader 28 des Kabels der schrankinternen Verdrahtung eine Umbiegung der Ader 26 des Feldkabels notwendig ist, einhergehend mit dem schematisch skizzierten erforderlichen Platzbedarf 30, der in dem erfindungsgemäßen Leittechnikschrank 10 eingespart werden kann.

## Patentansprüche

1. Leittechnikschrank (10) für eine Industrieanlage, mit wenigstens einer innerhalb des Leittechnikschranks (10) angeordneten Anschlussklemme (16), die wenigstens eine Klemmvorrichtung (18) zum Anschluss wenigstens einer Ader (26) eines von außerhalb des Leittechnikschranks (10) zugeführten Kabels aufweist, und ferner wenigstens eine weitere Klemmvorrichtung (18) zum Anschluss wenigstens einer Ader (28) eines Kabels einer internen Verdrahtung des Leittechnikschranks (10) aufweist, wobei jede Klemmvorrichtung (18) eine Einführ-Richtung aufweist, in welcher die Ader (26, 28) zum Anschluss an die Anschlussklemme (16) in die Klemmvorrichtung (18) eingeführt wird, **dadurch gekennzeichnet, dass** die Einführ-Richtung der Klemmvorrichtung (18), die zum Anschluss der Ader (26) des von außerhalb des Leittechnikschranks (10) zugeführten Kabels vorgesehen ist, gegenüber der Einführ-Richtung der Klemmvorrichtung (18), die zum Anschluss der Ader (28) des Kabels der internen Verdrahtung des Leittechnikschranks (10) vorgesehen ist, um einen vorgegebenen Winkel geneigt ist.

2. Leittechnikschrank (10) nach Anspruch 1, **dadurch gekennzeichnet, dass** der vorgegebene Winkel ein rechter Winkel ist.

3. Leittechnikschrank (10) nach Anspruch 1 oder 2, **dadurch gekennzeichnet, dass** die Anschlussklemme (16) eine abgewinkelte Anschlussklemme (16) ist.

4. Leittechnikschrank (10) nach einem der vorangehenden Ansprüche **dadurch gekennzeichnet, dass** die Anschlussklemme (16) an einer Schrankwand des Leittechnikschranks (10) angeordnet ist.

5. Leittechnikschrank (10) nach Anspruch 4, **dadurch gekennzeichnet, dass** die Schrankwand eine Rückwand (12) ist.

6. Leittechnikschrank (10) nach einem der vorangehenden Ansprüche, **dadurch gekennzeichnet, dass** die Anschlussklemme (16) auf einer Montageplatte angebracht ist, die innerhalb des Leittechnikschranks (10) angebracht ist.

7. Leittechnikschrank (10) nach einem der vorangehenden Ansprüche, **dadurch gekennzeichnet, dass** der Leittechnikschrank (10) eine Seitenwand (14) aufweist, in der eine Öffnung zur Durchführung des von außerhalb des Leittechnikschranks (10) zugeführten Kabels ausgebildet ist.
